# EUROPÄISCHE PATENTANMELDUNG

(11) **EP 0 576 921 A1**
(43) Veröffentlichungstag der Anmeldung: **05.01.1994**
(21) Anmeldenummer: 93109647.3
(22) Anmeldetag: 16.06.1993
(51) Int. Cl.: G06F 11/26

(54) **Elektronischer Baustein mit einer taktgesteuerten Schiebregisterprüfarchitektur (Boundary-Scan)**

(30) Priorität: 30.06.1992 DE 4221435
(71) Anmelder: SIEMENS AKTIENGESELLSCHAFT, D-80333 München (DE)
(72) Erfinder: Ritter, Hartmut, Dipl.-Phys., D-8524 Neunkirchen am Brand (DE); Rossow, Carsten, Dipl.-Ing., D-1000 Berlin 41 (DE); Müller, Bruno, Dipl.-Ing., D-8000 München 83 (DE); Riedel, Manfred, D-8061 Röhrmoos (DE); Lehner, Ernst, Dipl.-Ing., D-8000 München 81 (DE)

(57) **Zusammenfassung**

Eine auf einem elektronischen Baustein integrierte taktgesteuerte Schieberegisterprüfeinrichtung (Boundary-Scan) weist ein Schieberegister aus Registerelementen auf. Diese Registerelemente bilden jeweils einen Signalpfad zur Verbindung eines digitalen Schaltungsein-/ausgangs einer bausteininternen Schaltungsanordnung mit einem Bausteinanschluß und jeweils einen Schiebepfad zur Verbindung mit benachbarten Registerelementen. In der Prüfeinrichtung ist ein Betriebsmodus aktivierbar, bei dem wenigstens eine Sequenz von n Registerelementen (BSC) ein rückgekoppeltes Schieberegister bilden. Dieses rückgekoppelte Schieberegister dient zur Erzeugung einer n-bitbreiten, an Bausteinanschlüsse (BA) ausgebbaren Bitmusterfolge oder zur Signaturbildung aus einer n-breiten, bausteinanschlußseitig den Registerelementen zugeführten Bitmusterfolge.

## Beschreibung

Die Erfindung betrifft einen elektronischen Baustein gemäß dem Oberbegriff des Patentanspruchs 1 und ein Registerelement für ein Schieberegister einer Prüfeinrichtung zur Realisierung einer taktgesteuerten Schieberegisterprüfarchitektur gemäß dem Oberbegriff des Patentanspruchs 5.

Der hohe Komplexitätsgrad von integrierten Schaltungssystemen und die erreichte Miniaturisierung im Bereich der Verbindungs- und Aufbautechniken elektronischer Baugruppen lassen die als konventionelle Prüfverfahren bekannten Funktions- und "In Circuit"-Tests immer häufiger nur mit unwirtschaftlichem Aufwand zum Einsatz kommen. Zunehmend an Bedeutung gewinnt deshalb eine andere Art von Prüfverfahren, das eine in dem Baustein integrierte Prüfeinrichtung nutzt und als "Boundary-Scan-Verfahren" bekannt ist.

Wesentliches Charakteristikum bei dieser Prüfeinrichtung ist ein zwischen den Bausteinanschlüssen und den Schaltungsanschlüssen eingefügtes Schieberegister, das die serielle Einstellung und Beobachtung aller Bausteinanschlüsse ermöglicht. Über eine normierte Schnittstelle kann dieses Schieberegister auf dem Baustein gesteuert und die Schieberegister von mehreren Bausteinen auf einer Baugruppe z.B. zu einer Ringstruktur verbunden werden. Damit lassen sich auf einer Baugruppe Testdaten ein-und ausschieben, wodurch eine die einzelnen Bausteine als auch deren Verbindungsleitungen betreffende Fehlerlokalisierung ermöglicht wird.

Über prüftechnikspezifische Bausteinanschlüsse kann die "Boundary-Scan-Prüfeinrichtung" eines Bausteins entsprechend dem "IEEE-Standard 1149.1" auf unterschiedliche Betriebsweisen eingestellt werden.

In einem sogenannten externen Testmodus lassen sich die Verbindungsleitungen zwischen Bausteinen testen. Dazu werden über einen seriellen Eingang Testmuster in die Boundary-Scan-Ringstruktur eingeschoben. Die resultierenden Testantworten lassen sich anschließend über einen seriellen Schiebeausgang über die Boundary-Scan-Ringstruktur wieder ausschieben. Da Fertigungsfehler bei Baugruppen überwiegend Leiterbahnen betreffen und die Bausteine bereits vorgetestet sind, ist dieser standardmäßig enthaltene Modus bisher der wichtigste Anwendungsfall.

Eine weitere Betriebsweise ist der sogenannte "Sample-Testmodus". Dieser Testmodus übernimmt während des Normalbetriebs des Bausteins eine Stichprobe der anliegenden Betriebsdaten in die Boundary-Scan-Ringstruktur. Diese werden anschließend seriell ausgeschoben. Damit lassen sich die Signale zwischen den Bausteinen auf einer Baugruppe ohne mechanische Kontaktierung beobachten. Dieser Testmodus kann sowohl zur Fehlersuche bei Prototypen als auch für den Betriebstest verwendet werden, ohne den Normalbetrieb zu unterbrechen.

Eine weitere Betriebsweise ist der sogenannten interne Testmodus. In diesem wird die auf dem Baustein befindliche Schaltung, die gewissermaßen den Bausteinkern darstellt, getestet. Dieser Modus ist speziell für den Fertigungs- und Systemtest vorgesehen. Hierzu werden Testmuster über die Boundary-Scan-Ringstruktur zu den Eingängen der Bausteine transportiert. Anschließend wird mit diesen Testmustern der Bausteinkern stimuliert. Die resultierenden Testantworten werden von an Schaltungsausgängen angeordneten Registerzellen des Boundary-Scan-Schieberegisters übernommen und seriell ausgeschoben.

Grundlagenkenntnisse zum Boundary-Scan-Prüfverfahren als auch zum internen Aufbau einer Prüfeinrichtung und insbesondere zum Aufbau der Registerelemente eines Boundary-Scan-Schieberegisters sind z. B. aus der Zeitschrift ELECTRONIC 9 vom 28.04.1989 "Der JTAG-Boundary-Scan" von Dipl.-Ing. J. Maierhofer und Dipl.-Ing. B. Müller oder aus "Selbsttest digitaler Schaltungen", 1990, Oldenburg Verlag, von H. Gerner, B. Müller und G. Sandweg, ISBN 3-486-21765-8, zu beziehen.

Aufgrund des noch relativ wenig verbreiteten Boundary-Scan-Prüfverfahrens ist die Anzahl von Bausteintypen, die mit einer entsprechenden Prüfeinrichtung versehen sind, bisher noch gering. Im allgemeinen sind deshalb auf Baugruppen mit durch eine Boundary-Scan-Architektur versehenen Bausteinen derzeit auch noch konventionelle Bausteine angeordnet, so daß die gesamte Baugruppe nicht ausschließlich mit dem Boundary-Scan-Verfahren geprüft werden kann und in der Regel noch ein konventionelles Prüfverfahren zusätzlich erforderlich wird.

Aufgabe der vorliegenden Erfindung ist es, die in einem, mit einer Boundary-Scan-Architektur versehenen Baustein befindliche Prüfeinrichtung so zu modifizieren und zu ergänzen, daß von dem betreffenden Baustein aus eine Prüfung anderer, auf der gleichen Baugruppe befindlichen Bausteine, die keine Boundary-Scan-Architektur aufweisen, durchführbar wird oder zumindest unterstützt werden kann.

Gelöst wird diese Aufgabe ausgehend von den Merkmalen des Oberbegriffs nach Patentspruch 1 bzw. Patentanspruch 5 erfindungsgemäß durch die Merkmale des kennzeichnenden Teils des Patentanspruchs 1 bzw. 5.

Der vorliegenden Erfindung liegt die Idee zugrunde, in einer Boundary-Scan-Prüfeinrichtung, die als standardisierte Testhilfe für Baugruppen (IEEE Standard 1149.1) bekannt ist, eine Betriebsweise zu implementieren, bei der Registerelemente mit Hilfe zusätzlicher Schaltelemente zu einem rückgekoppelten Schieberegister verbunden werden. Diese rückgekoppelten Schieberegister können dann zur Erzeugung von pseudozufälligen Testmustern oder zur Auswertung von Testantworten (Signaturanalyse) verwendet werden.

Die Erzeugung von Testmustern bzw. die Signaturanalyse mit Hilfe von rückgekoppelten Schieberegistern ist für sich aus der bereits eingangs genannten Literaturstelle "Selbsttest digitaler Schaltungen" Seiten 91 bis 173, bekannt.

Die von einem rückgekoppelten Schieberegister erzeugten Bitmuster werden an den Bausteinanschlüssen ausgegeben und gelangen über Verbindungsleitungen an benachbarte Bausteine, die keine Boundary-Scan-Prüfeinrichtung aufweisen. Eine Prüfung eines solchen Bausteins mittels eines Funktionstests oder eines "In-Circuit"-Tests kann sich erheblich vereinfachen, da von außerhalb der Baugruppe zur Prufung des Bausteins keine Bitmusterfolge zugeführt werden muß. In Fällen, in denen ein betreffender Baustein, z. B. ein Speicherbaustein, mit seinen Ein- und Ausgangsleitungen an einen erfindungsgemäß ausgebildeten Baustein angeschlossen ist, kann ein Funktionstest oder ein
"In-Circuit"-Test des betreffenden Bausteins entfallen, da die Reaktionen, also die Testantworten, eines mit einem erzeugten Bitmuster beaufschlagten Bausteins wieder in Form einer Bitmustersequenz dem erfindungsgemäß ausgebildeten Baustein zur Signaturbildung zugeführt werden, und die ermittelte Signatur als Prüfergebnis von dem erfindungsgemäß ausgebildeten Baustein über die standardisierte Boundary-Scan-Schnittstelle ausgegeben wird.

In einer Weiterbildung eines erfindungsgemäßen Bausteins ist zur Funktionsüberprüfung der rückgekoppelten Schieberegister ein Selbsttestmodus einschaltbar, in dem die von einem rückgekoppelten Schieberegister erzeugten Bitmuster bausteinintern einem zur Signaturbildung dienenden rückgekoppelten Schieberegister zugeführt werden. In diesem Betriebsmodus der Prüfeinrichtung kann diese also selbst überprüft werden. Dies findet insbesondere bei der Herstellung eines Bausteins Anwendung, da beim Selbsttestmodus der Baustein nicht in einer Baugruppe angeordnet sein muß. Ein erfindungsgemäß ausgebildetes Registerelement nach Anspruch 5 ist universell anwendbar und bringt den wesentlichen Vorteil mit sich, daß auf dem Signalpfad zwischen Schaltungsein-/-ausgang und Bausteinanschluß keine zusätzliche Laufzeitverzögerung entsteht.

Ein wesentlicher Vorteil der Erfindung ist zudem darin zu sehen, daß die Prüfbarkeit von Bausteinen ohne Boundary-Scan-Architektur lediglich durch eine Ergänzung einer bestehenden Boundary-Scan-Prüfeinrichtung in einem Baustein erzielt wird und damit keine zusätzlichen Bausteine auf der Baugruppe erforderlich werden. In der Regel sind mit Boundary-Scan-Prüfeinrichtungen versehene Bausteine kundenspezifisch gestaltete Bausteine (ASICS), auf denen eine durch wenigstens einen Betriebsmodus ergänzte Boundary-Scan-Prüfeinrichtung hinsichtlich der für die Ergänzung zusätzlich erforderlichen Schaltungselemente keine Probleme bereitet.

Vorteilhafte Weiterbildungen des Gegenstandes nach Anspruch 1 sind in den Unteransprüchen 2 bis 4 und des Gegenstandes nach Anspruch 5 in den Unteransprüchen 6-8 angegeben.

Zum besseren Verständnis der Erfindung und ihrer Weiterbildungen und insbesondere der damit erzielbaren Vorteile werden im folgenden anhand der Zeichnung Ausführungsbeispiele näher erläutert. Dabei zeigen
- FIG 1: eine schematische Blockdarstellung eines elektronischen Bausteins mit einer rückgekoppelte Schieberegister bildenden Boundary-Scan-Prüfeinrichtung zum Bitmustertest externer Speicherbausteine,
- FIG 2: eine schematische Blockdarstellung der Elemente einer für einen Bitmustertest nach FIG 1 ergänzten Boundary-Scan-Prüfeinrichtung,
- FIG 3: eine Übersichtstabelle über die in der Prüfeinrichtung einstellbaren Betriebsmodi,
- FIG 4: ein Blockschaltbild für ein ergänztes "TAP-Interface" nach FIG 2,
- FIG 5: eine Übersichtstabelle der Steuersignale in Abhängigkeit der Betriebsmodi,
- FIG 6: einen Zustandsgraphen für einen "Local-BIST-Controller" nach FIG 2,
- FIG 7: eine Schaltungsanordnung für ein bekanntes Schieberegisterelement,
- FIG 8: eine Schaltungsanordnung für ein zur Testmustererzeugung dienendes rückgekoppeltes Schieberegister (LFSR),
- FIG 9: eine Schaltungsanordnung für ein zur Testmustererzeugung dienendes rückgekoppeltes Schieberegister (NFSR),
- FIG 10: eine Schaltungsanordnung für ein Schieberegister-element zur Realisierung eines der Signaturbildung dienenden rückgekoppelten Schieberegisters, und
- FIG 11: eine Schaltungsanordnung für ein zur Signaturbildung dienendes rückgekoppeltes Schieberegister (MISR).

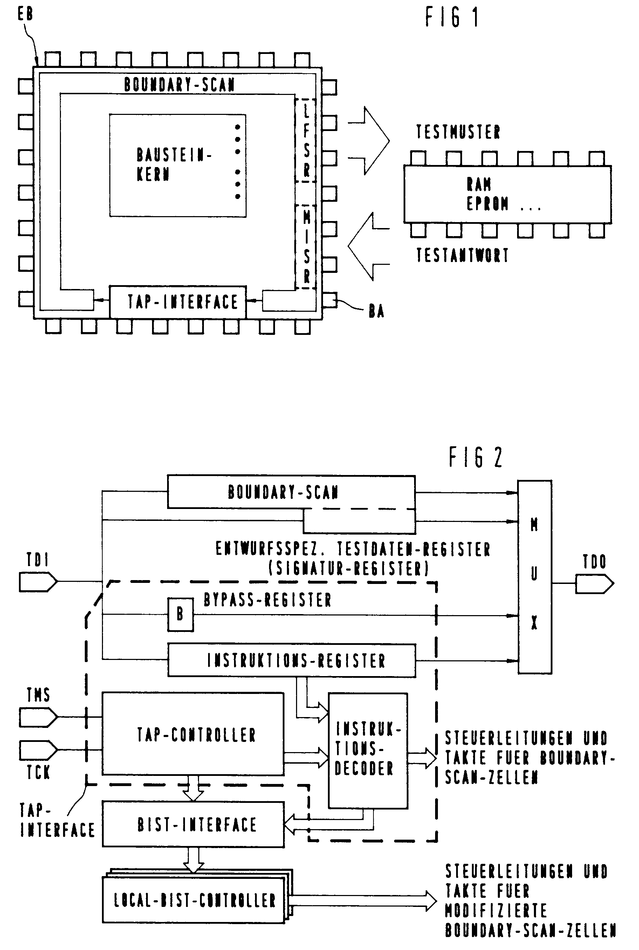

FIG 1 zeigt in einer vereinfachten Darstellung den prüftechnischen Zusammenhang zwischen einem Baustein EB mit Boundary-Scan-Prüfeinrichtung und einem benachbarten Baustein auf einer Baugruppe, z. B. einem Speicherbaustein, ohne Boundary-Scan-Prüfeinrichtung. Bei dem Baustein EB mit Boundary-Scan-Prüfeinrichtung sind zusätzliche Betriebsmodi vorgesehen, die eine Erzeugung und Ausgabe von Bitmustersequenzen an den benachbarten Bausteinen bewirken. Die als Reaktion, also als Testantwort, auf die ausgesendete Bimusterfolge in dem benachbarten Baustein entstehende Bitmusterfolge wird dem prüfenden Baustein EB wieder zugesendet und es wird daraus mittels eines rückgekoppelten Schieberegisters eine Signatur gebildet, die über die Funktion des benachbarten Bausteins Rückschlüsse erlaubt. Diese Betriebsweise der Boundary-Scan-Prüfeinrichtung ist zusätzlich zu den standardmäßig vorhandenen Betriebsweisen implementiert und diese werden durch die zusätzliche Betriebsweise nicht eingeschränkt. Im folgenden wird auf die standardmäßig vorhandenen Betriebsweisen nicht näher eingegangen. Die zusätzliche Betriebsweise wird im weiteren kurz als Umfeldtest ('Environment-Test') bezeichnet.

FIG 2 zeigt in einer vereinfachten Blockdarstellung die für den Umfeldtest ergänzte Architektur einer Boundary-Scan-Prüfeinrichtung. Die Prüfeinrichtung beinhaltet neben den Boundary-Scan-Zellen (Registerelemente) zur Bildung eines Schieberegisters, eine Schnittstellensteuerung, die als "TAP-Interface" (Test Access Port) bezeichnet wird und sich aus einem Instruktionsregister, einem Bypassregister, einer Ablaufsteuerung (TAP-Controller) und einem Instruktionsdecoder zusammensetzt.

Die Ablaufsteuerung (TAP-Controller) stelle eine Schaltungsanordnung zur Realisierung der Funktionsweise eines endlichen Automaten mit sechzehn standardisiert vorgegebenen Zuständen dar. Die Zustandsübergänge hängen von einer, an einem als TMS-Eingang (Test Mode Select) bezeichneten Eingang anliegenden Signalfolge ab. Die Ausgangssignale der Ablaufsteuerung (TAP-Controller) dienen als Eingabe in den Instruktionsdecoder.

Das Instruktionsregister wird seriell über einen als TDI-Eingang (Test Data Input) bezeichneten Eingang mit Steuerbefehlen geladen und über einen als TDO-Ausgang (Test Data Output) bezeichneten Ausgang ausgelesen. Der IEEE-Standard 1149.1 schreibt als Minimalversion ein zwei Bit breites Instruktionsregister vor. Dies kann jedoch für die Einführung zusätzlicher Befehle erweitert werden.

Der Instruktionsdecoder erzeugt Steuersignale für den Testablauf. Als Eingabe dienen sowohl der Inhalt des Instruktionsregisters, als auch die Ausgangssignale der Ablaufsteuerung (TAP-Controller). Steuersignale zur Konfiguration der Boundary-Scan-Zellen werden direkt aus dem jeweiligen Befehl abgeleitet. Takte für die Boundary-Scan-Zellen hängen zusätzlich vom Zustand der Ablaufsteuerung (TAP-Controller) und von einem über einen als TCK-Eingang (Test Clock) zugeführten Testtakt ab.

Über das standardmäßige vorhandene Bypassregister kann der Testdateneingang TDI (Test Data Input) mit dem Testdatenausgang TDO kurzgeschlossen werden. Dadurch wird der Schiebeweg auf der Baugruppe und folglich die Testzeit verkürzt, falls nicht alle Bausteine oder Verbindungen zugleich getestet werden sollen.

Für einen Transport eines Testergebnisses (Signatur) werden die zur Signaturbildung dienenden Boundary-Scan-Zellen zu einem entwurfsspezifischen Testdatenregister umkonfiguriert, ohne den 'IEEE'-Standard zu verletzen.

In der FIG sind die zur Realisierung des Umfeldtestes notwendigen Ergänzungen einer standardisierten Boundary-Scan-Architektur schraffiert dargestellt. Das Instruktionsregister ist um eine Bitstelle auf drei Bit ergänzt worden, um zwei zusätzliche Betriebsmodi (zwei Varianten des Umfeldtests) in der Prüfeinrichtung codieren zu können.

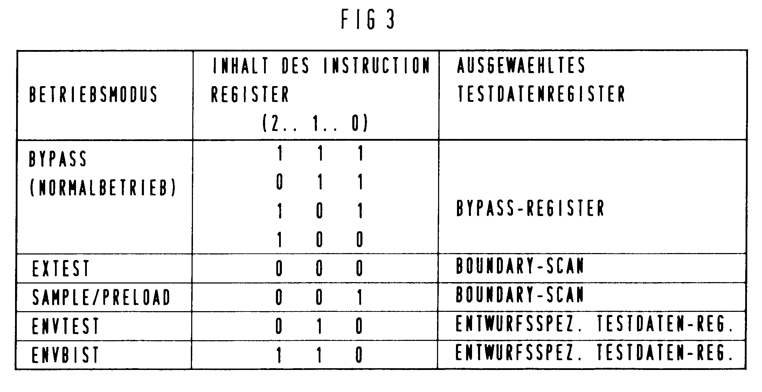

In FIG 3 ist eine Übersicht der in Abhängigkeit der Bitkombination im Instruktionsregister auswählbaren Betriebsmodi der Boundary-Scan-Prüfeinrichtung angegeben.

Bei den für den Umfeldtest zusätzlich eingeführten Betriebsmodi 'ENVTEST' und 'ENVBIST' werden die zu einem Signaturregister erweiterten Boundary-Scan-Zellen aus der Boundary-Scan-Schiebekette herausgelöst und zu einem eigenen Testdatenregister verschaltet. Damit kann eine Signatur direkt über den Testdatenausgang TDO ausgeschoben werden.

Die Initialisierung, Steuerung und Auswertung des Umfeldtests folgt über den nach IEEE 1149.1 standardisierten Test-Access-Port. Dafür ist das 'TAP-Interface' gegenüber einem bekannten, nur die Minimalfunktion des Standards unterstützenden 'TAP-Interface' modifiziert.

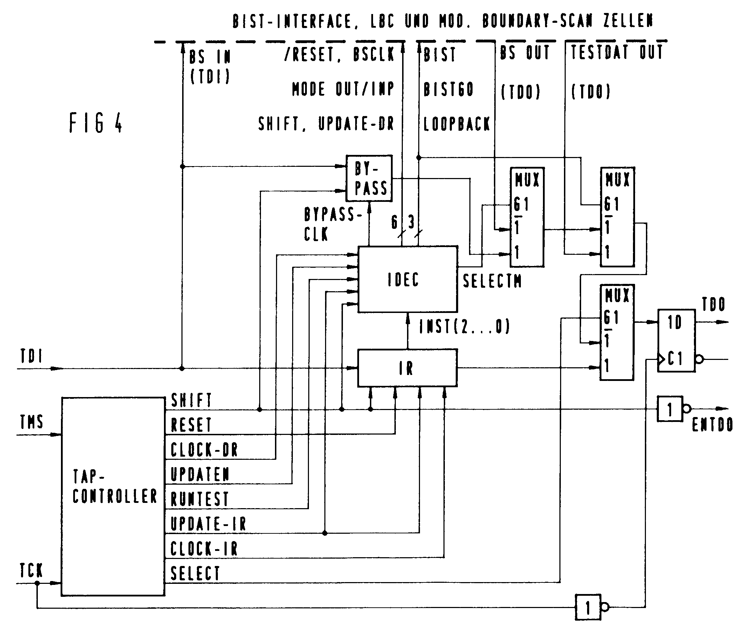

In FIG 4 sind anhand eines Blockschaltbildes die Elemente eines modifizierten 'TAP-Interface' dargestellt. Das 'TAP-Interface' ist ein Teil der Prüfeinrichtung und ist über Steuerleitungen, wie am oberen Rand der FIG angegeben, mit weiteren Teilen der Prüfeinrichtung, nämlich einem sogenannten 'BIST-Interface', einem oder mehreren 'Local-BIST-Controller' und den zur Bildung von rückgekoppelten Schieberegistern modifizierten Boundary-Scan-Zellen verbunden. Eine Erläuterung des 'BIST-Interface', der 'Local-BIST-Controller' und der modifizierten Boundary-Scan-Zellen wird zunächst zurückgestellt.

Wie bereits erwähnt, ist die Funktion der Ablaufsteuerung (TAP-Controller) die eines Automaten, bei dem die Anzahl der Zustände sowie die Zustände selbst und deren Übergänge genormt sind und nicht verändert werden. Zur Erläuterung der Zustände und der Übergänge wird auf die eingangs genannte Literaturstelle ("Selbsttest digitaler Schaltungen", Seiten 83 bis 84) verwiesen. Zur Implementierung der für den Umfeldtest zusätzlich eingeführten Betriebsmodi muß der standardmäßig vorgegebene 'TAP-Controller', ohne den Standard zu verletzen, geringfügig dazu erweitert werden, den standardmäßig vorgesehenen Zustand "RUNTEST" zu decodieren, d.h. auf einer Ausgangsleitung zu melden. Anstelle des bisherigen Ausgangssignales UPDATE-DR des 'TAP-Controllers' wird ein Ausgangssignal UPDATEN erzeugt. Im UPDATE-DR-Zustand des 'TAP-Controllers' werden mit der fallenden Flanke die ausgewählten Register geladen. Das Signal UPDATE-DR wird erst im Instruktionsdecoder IDEC endgültig decodiert.

Der Instruktionsdecoder IDEC erzeugt die meisten internen Steuersignale. Der Codeinhalt (INST 2,1,0) des Instruktionsregisters IR und die Ausgangssignale CLOCKDR, UPDATEN, UPDATEIR und RUNTEST sowie SHIFT des 'TAP-Controllers' dienen als seine Eingangssignale.

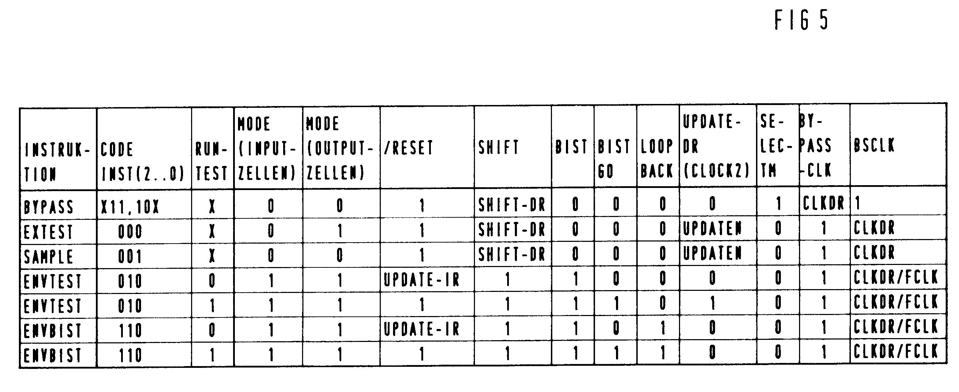

In FIG 5 ist eine Tabelle über die zur Steuerung der modifizierten Boundary-Scan-Zellen dienenden Ausgangssignale des Instruktionsdecoders IDEC dargestellt.

Ist eine der beiden den Umfeldtest aktivierenden Instruktionen ENVTEST oder ENVBIST in das Instruktionsregister IR geladen, so schaltet das Ausgangssignal BIST des Instruktionsdecoders IDEC das Testdatenregister frei, um im Zustand SHIFT-DR eine während des Tests ermittelte Signatur über den Testdatenausgang TDO ausschieben zu können.

Mit dem Ausgangssignal BISTGO werden die 'Local-BIST-Controller' aktiviert und die Boundary-Scan-Zellen zu Testmustergeneratoren oder zu Testantwortauswertern (Signaturbildung) umkonfiguriert. Das Signal BISTGO ist aktiv, wenn BIST=1 gilt und der 'TAP-Controller' sich gleichzeitig im RUNTEST-Zustand befindet (RUNTEST = 1).

Mit dem Ausgangssignal LOOPBACK des Instruktionsdecoders IDEC wird ein Selbsttestmodus (ENVBIST) innerhalb des Umfeldtests aktiviert. Schieberegisterzellen, die zur Signaturbildung vorgesehen sind, weisen Eingangswähler auf, die im Selbsttestmodus Ausgänge von Testmustergeneratoren unmittelbar auf die Eingänge von zur Erzeugung einer Signatur dienenden rückgekoppelten Schieberegister umschalten. Damit können sowohl die Testmustergeneratoren, die zur Bildung einer Signatur dienenden rückgekoppelten Schieberegister als auch das 'BIST-Interface', die 'Local-BIST-Controller' und die wesentlichen Teile der Boundary-Scan-Prüfeinrichtung überprüft werden.

Die an die Boundary-Scan-Zellen geführten 'Mode'-Steuerleitungen sind während des Umfeldtests so eingestellt, daß an den als Testmustergenerator dienenden Schieberegister-zellen am Bausteinanschluß die erzeugten Testmuster und an allen anderen die mit dem Betriebsmodus SAMPLE/PRELOAD eingeschobenen Daten anliegen.

Das an die Boundary-Scan-Zellen geführte Rücksetzsignal RESET wird durch eine UND-Verknüpfung des Ausgangssignales BIST des Instruktionsdecoders IDEC mit dem 'TAP-Controller'-Ausgangssignal UPDATE-IR erzeugt. Die Funktion des Ausgangssignales UPDATEDR des Instruktionsdecoders IDEC entspricht dem gleichnamigen Ausgangssignal eines standardmäßig ausgebildeten 'TAP-Controllers'.

Die Signale BYPASSCLK und BSCLK werden in Abhängigkeit der jeweiligen Instruktion aus dem Ausgangssingal CLOCKDR des 'TAP-Controllers' abgeleitet. Das Signal UPDATE-DR ist nur in den Betriebsmodi SAMPLE/PRELOAD und EXTEST aktivierbar. Dabei bleiben alle mit der Instruktion SAMPLE/PRELOAD vorab eingeschobenen definierten Werte in der zweiten Stufe der Boundary-Scan-Zellen erhalten. Im Betriebsmodus ENVTEST hingegen muß die in den Boundary-Scan-Zellen vorhandene zweite taktgesteuerte Kippstufe (LATCH) während des RUNTEST-Modus transparent sein. Dies wird durch eine entsprechende Verknüpfung im BIST-Interface bewerkstelligt (vgl. dazu "1" in der Spalte UPDATE-DR in FIG 5).

Das 'BIST-Interface' besteht aus einer relativ einfach ausgebildeten Synchronisations- und Selektionsschaltung aus wenigen Gatterelementen.

Im Sinne eines modularen Aufbaus einer "Boundary Scan"-Architektur - wie in FIG 2 dargestellt - ist das 'BIST-Interface' mit einer standardisierten Schnittstelle ausgestattet. Der Aufbau des BIST-Interface richtet sich nach den spezifischen Anforderungen und kann von einem Fachmann ohne weiteres anhand einer Funktionsangabe erstellt werden. Das 'BIST-Interface' startet die "Local-BIST-Controller", es sorgt für die Umkonfiguration der "Boundary Scan"-Zellen und setzt die Testmustergeneratoren und Signaturregister in der Startphase der beiden Testmodi ENVTEST und ENVBIST zurück.

Für alle an diesen beiden Testmodi beteiligten "Boundary Scan"-Zellen müssen die Steuersignale UPDATE-DR und SHIFT im BIST-Interface modifiziert werden (vgl. hierzu FIG 5). Um die Testmuster während des Umfeldtests an Bausteinanschlüsse des Bausteins anlegen zu können, müssen die Latches in den zu Testmuster-Generatoren modifizierten "Boundary Scan"-Zellen während des Tests transparent geschaltet sein (UPDATE-DR = 1).

Die Testmustergenerator- und Testantwortauswertefunktionen werden im Schiebemode der beteiligten "Boundary Scan"-Zellen ausgeführt. Daher ist das 'SHIFT'-Signal während der beiden Tests zu aktivieren. Das 'SHIFT'-Signal ist bei beiden Instruktionen auch im Zustand CAPTURE-DR aktiv, daher wird ein Überschreiben der Signatur vor dem Ausschieben verhindert.

Der Takt für die Schieberegisterzellen wird im einfachsten Fall aus dem zu TCK synchronisierten Takt CLOCK-DR gewonnen. Falls aus Performance-Gründen im Zustand RUN-Test ein TCK-asynchroner Systemtakt verwendet wird, muß das BIST-Interface eine Taktumschaltung ohne Störimpulse durchführen, da das Ausschieben der Signatur in jedem Fall synchron mit TCK erfolgen muß.

Die Modularität der "Boundary Scan"-Architektur wird insbesondere dadurch gewährleistet, daß alle für den Test der externen Module notwendigen Takte und Steuerleitungen individuell in einem jeweiligen "Local-BIST-Controller" erzeugt werden.

Ein "Local-BIST-Controller" beinhaltet die anwendungsspezifischen Bestandteile, d. h. die für eine individuelle Ansteuerung eines zu prüfenden Bausteins, z. B. eines RAM-Speichers, erforderlichen Schaltungsteile, für die Steuerung des Umfeldtests. Der "Local-BIST-Controller" wird durch das Signal BISTGO aktiviert und erzeugt daraufhin Takte für die Testmustergeneratoren und Testantwortauswerter. Der Test läuft solange, bis ein Testendekriterium gültig wird. Dies kann beispielsweise durch Zählen der Testtakte oder Vergleich des Testmustergenerators mit einem geeigneten Endezustand gewonnen werden. Nach Ablauf des Tests verharrt der "Local-BIST-Controller" in seinem Endzustand, bis das Testergebnis (Signatur) ausgelesen und eine neue Instruktion eingeschoben wird. Im Funktionsmodus des Bausteins und allen Testmodi, außer ENVTEST und ENVBIST, bleibt ein jeweiliger "Local-BIST-Controller" inaktiv (BISTGO = 0). Die Funktion eines "Local-BIST-Controllers" wird im folgenden anhand eines Beispiels erläutert.

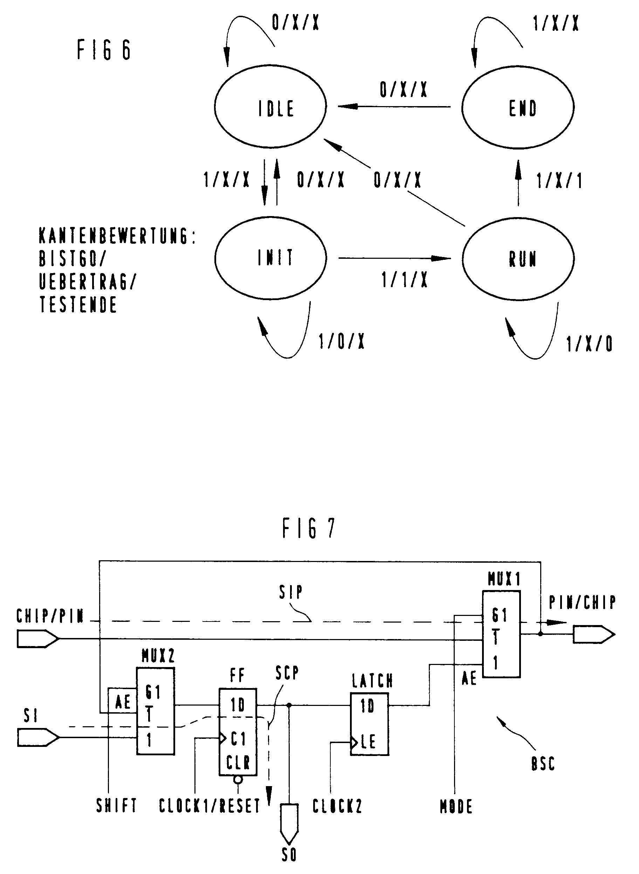

FIG 6 zeigt einen Zustandsgraph eines "Local-BIST-Controllers". Ein "Local-BIST-Controller" für den Umfeldtest eines RAM-Speichers und eines EPROM-Speichers besteht jeweils aus einem universell verwendbaren Controllerkern mit vier Zuständen und einem individuellen Timinggenerator (nicht dargestellt). Ein erster Zustand, der als "Idle" bezeichnet ist, dient als Wartezustand und wird verlassen, sobald das 'BIST-Interface' den ENVTEST-oder den ENVBIST-Modus startet (BISTGO = 1). Mit BISTGO = 0 (ENVTEST bzw. ENVBIST nicht aktiv) kehrt der "Local-BIST-Controller" aus allen Zuständen in diesen Wartezustand zurück.

In einem zweiten Zustand, der als INIT bezeichnet wird, wird der RAM-Speicher mit einem Hintergrundmuster beschrieben und ein Rundenzähler gestartet. Nach dem ersten Durchlauf (Übertrag = 1) enthält jede Speicherzelle einen definierten Wert. Beim EPROM-Speichertest passiert in dieser Phase nichts. Der Ubergang in einen dritten, mit RUN bezeichneten Zustand erfolgt mit dem nächsten Testtakt.

In einem RUN-Zustand wird beim RAM-Speicher ein Testalgorithmus durchgeführt. Der EPROM-Speicher wird hier einmal vollständig ausgelesen. Mit einem Testendesignal wird dieser Zustand verlassen.

In einem als END-Zustand bezeichneten vierten Zustand wird eine Signatur in den modifizierten "Boundary Scan"-Zellen eingefroren. Auch der Takt für die Testmustergeneratoren wird angehalten. Das Testdatenregister kann ausgeschoben und verglichen werden.

In FIG 7 ist der Schaltungsaufbau einer zur Bildung von rückgekoppelten Schieberegistern zu ergänzenden Boundary-Scan-Aus-/-Eingangszelle BSC dargestellt. Eine bekannte Boundary-Scan-Schieberegisterzelle BSC besteht aus einem Signalpfad SIP, in dem ein Eingangswähler MUX1 angeordnet ist. Der Signalpfad SIP verbindet, je nach dem, ob die Registerzelle BSC als Ein- oder Ausgangszelle dient, einen Schaltungsein- bzw. Schaltungsausgang mit einem Bausteinanschluß (PIN). Des weiteren besteht die Registerzelle BSC aus einem Schiebepfad SCP zur Verbindung mit benachbarten Registerzellen in einem Schieberegister. Im Schiebepfad SCP ist eingangsseitig ein Eingangswähler MUX2 angeordnet, dem eine taktgesteuerte Kippstufe FF nachgeschaltet ist. Ausgangsseitig ist der Eingangswähler MUX1 im Signalpfad SIP mit einem alternativen Eingang AE des im Schiebepfad SCP befindlichen Eingangswählers MUX2 verbunden. Für die Bildung eines rückgekoppelten Schieberegisters im Sinne der vorliegenden Erfindung ist die im Schiebepfad SCP angeordnete taktgesteuerte Kippstufe FF rücksetzbar ausgebildet, um einen reproduzierbaren Ausgangszustand im rückgekoppelten Schieberegister einstellen zu können. Der Ausgang dieser Kippstufe FF ist über ein 'LATCH' mit einem alternativen Eingang AE des im Signalpfad SIP angeordneten Eingangswählers MUX1 verbunden. In einer funktionellen Betrachtungsweise der dargestellten Registerzelle besitzt diese zwei Registerstufen. Die erste Registerstufe FF führt die Schiebefunktion aus, die zweite (LATCH) puffert die Daten und schottet den Bausteinanschluß (PIN) beim Schieben nach außen bzw. nach innen ab.

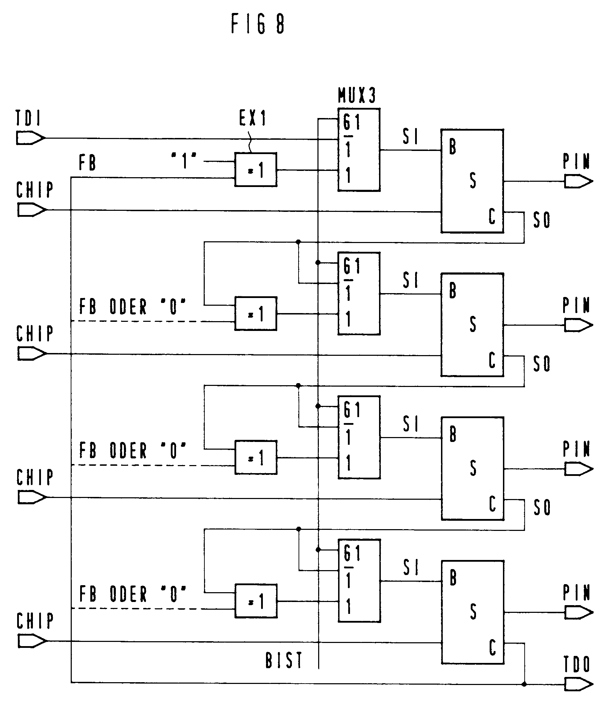

In FIG 8 ist ein Testmustergenerator in Form eines modularen linear rückgekoppelten Schieberegisters (LFSR) dargestellt. Den Registerzellen BSC nach FIG 7 ist jeweils ein Eingangswähler MUX3 im Schiebepfad SCP vorgeschaltet. An einem alternativen Eingang AE eines jeweiligen Eingangswählers MUX3 ist ein zur Einspeisung eines Rückkopplungspfades FB vorgesehenes EXCLUSIV-ODER-Gatter EX1 angeschlossen. Linear rückgekoppelte Schieberegister eignen sich zur Erzeugung von PSEUDO-RANDOM-Testmustern (vgl. hierzu auch die eingangs genannte Literaturstelle "Selbstest digitaler Schaltungen"). Mit einer modularen Form, bei der Exklusiv-Oder-Gatter im Schiebepfad zwischen den einzelnen Registerzellen liegen, lassen sich sehr regulär aufgebaute Schieberegisterschaltungen verwirklichen. Abhängig vom Rückkopplungspolynom muß an einigen Registerzellen der Ausgang FB (Feed Back) der in Schieberichtung letzten Registerzelle eingekoppelt werden. Unbenutzte Rückkopplungseingänge können fest auf Null gelegt werden. Auf Kosten der Regularität kann eine derartige Schaltung auch durch Entfernen redundanter Elemente minimiert werden.

Das Steuersignal BIST schaltet die Eingangswähler MUX3 vom normalen Schiebemodus des Boundary-Scan-Schieberegisters in einen Generatormodus. Durch Einkoppeln einer 'l' in die erste Stufe läuft das dargestellte linear rückgekoppelte Schieberegister (LFSR) nach dem Zurücksetzen aus dem Nullvektor heraus. Mit einem LFSR können maximal 2^{n-l} verschiedene Testmuster erzeugt werden.

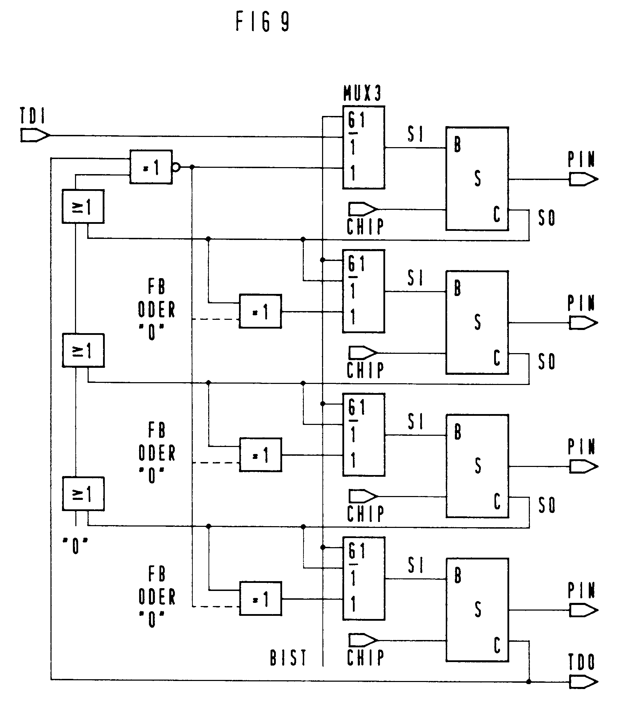

Will man einen erschöpfenden Testmustersatz mit allen 2ⁿ-möglichen Kombinationen erzeugen, so muß eine nichtlineare Modifikation der ansonsten linearen Rückkopplungsfunktion folgen. Ein solches nichtlinear rückgekoppeltes Schieberegister (NFSR, NON-LINEAR FEEDBACK SHIFT REGISTER) ist in FIG 9 dargestellt.

Bei der in FIG 9 gezeigten Schieberegisterschaltung handelt es sich um einen Testmustergenerator in Form eines modularen nichtlinear rückgekoppelten Schieberegister. Die bei einem NFSR üblicherweise verwendete NOR-Gatter-Rückkopplung (vgl. hierzu "Selbstest digitaler Schaltungen" Seite 117) wird bei der vorliegenden Schaltung mit einer Kaskade aus OR-Gattern realisiert.

Soll ein rückgekoppeltes Schieberegister zur Testantwortauswertung, also zur Signaturbildung dienen, sind die zur Bildung des rückgekoppelten Schieberegisters vorgesehenen "Boundary Scan"-Schieberegisterzellen nach FIG 7 etwas umfangreicher (als für die Testmustergenerierung) zu ergänzen.

Für die Bildung eines parallelen Signaturregisters (MISR: Multiple Input Signature Register) in einer modularen Form müssen für jede Registerstelle entweder der Rückkopplungswert FB oder ein digitaler "Nullpegel" (abhängig vom gewahlten Polynom), der Eingangswert der betreffenden "Boundary Scan"-Schieberegisterzelle und der Wert der in der Schiebekette vorhergehenden "Boundary Scan"-Schieberegisterzelle über EXCLUSIV-ODER-Gatter verknüpft werden.

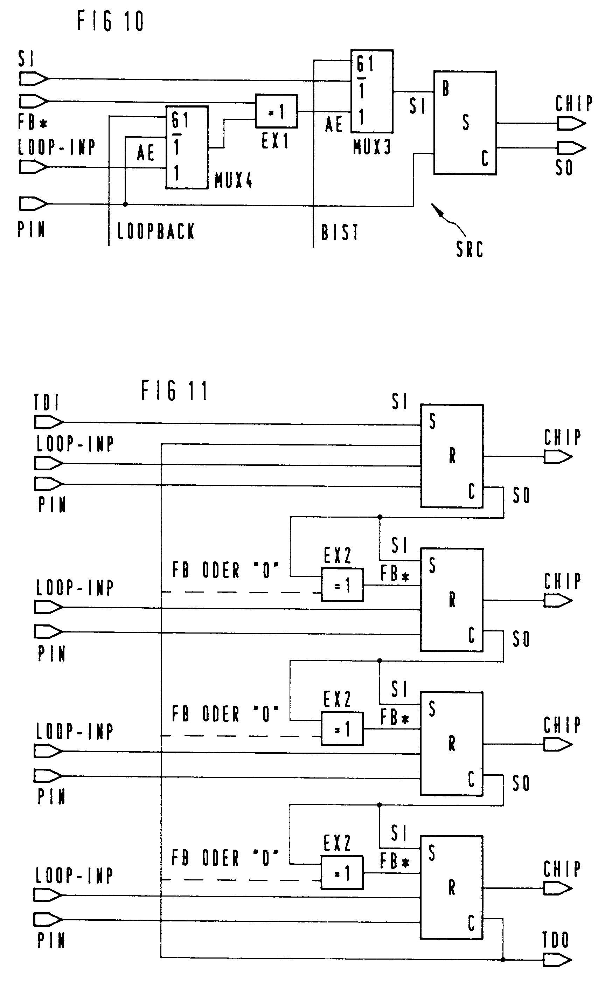

In FIG 10 ist eine Schaltungsanordnung für eine Signaturregistergrundzelle SRC dargestellt, die eine durch ein EXCLUSIV-ODER-Gatter EX1 und einen Eingangswähler MUX3 ergänzte Schieberegisterzelle BSC nach FIG 7 aufweist und außerdem mit einem weiteren Eingangswähler MUX4 versehen ist, der bei der ENVBIST-Instruktion einen "Loop back"-Selbsttestmodus ermöglicht. Dabei werden die mit den Ausgängen eines Testmustergenerators verbundenen Loop-INP-Eingänge des weiteren Eingangswählers MUX4 durchgeschaltet.

In FIG 11 ist eine Schaltungsanordnung für ein mit Signaturregisterzellen SRC nach FIG 10 aufgebautes, modulares Signaturregister (MISR) dargestellt. An welchen Registerstellen der Rückkopplungswert FB eingekoppelt werden muß, wird durch das gewählte Rückkopplungspolynom festgelegt. An den Stellen, an denen keine Einkopplung erfolgt, wird eine digitale Null an ein der Signaturregisterzelle SRC vorgeschaltetes EXCLUSIV-ODER-Gatter EX2 angelegt. Alternativ kann dieses auch entfallen und der Schiebepfadausgang SO der Vorgängerzelle kann direkt mit dem Eingang FB* verbunden sein.

## Patentansprüche

1. Elektronischer Baustein mit einer zumindest teilweise digitalen Schaltung und einer zur Realisierung einer bausteininternen taktgesteuerten Schieberegisterprüfarchitektur ("Boundary-Scan-"Architektur) dienenden Prüfeinrichtung, die ein Schieberegister aus Registerelementen mit je einem Signalpfad zur Verbindung eines digitalen Schaltungseingangs/ausgangs mit einem Bausteinanschluß und mit je einem Schiebepfad zur Verbindung mit benachbarten Registerelementen aufweist und die ein zustandsgesteuertes Schaltwerk zur Erzeugung von Statussignalen, ein Befehlsregister zur Aktivierung von Betriebsmodi und einen Befehlsdecoder zur Erzeugung von internen Steuersignalen aufweist,
**dadurch gekennzeichnet,**
daß in der Prüfeinrichtung wenigstens ein zusätzlicher Betriebsmodus aktivierbar ist, bei dem wenigstens eine Sequenz von n-Registerelementen (BSC) ein rückgekoppeltes Schieberegister bilden, das zur Erzeugung einer n-Bit breiten, an Bausteinanschlüsse (BA) ausgebbaren Bitmusterfolge oder zur Signaturbildung aus einer n-Bit breiten, bausteinanschlußseitig den Registerelementen zugeführten Bitmusterfolge ausgebildet ist.

2. Elektronischer Baustein nach Anspruch 1 mit einer Prüfschaltung zur Bildung wenigstens je eines rückgekoppelten Schieberegisters zur Erzeugung einer Bitmusterfolge und zur Signaturbildung aus einer Bitmusterfolge,
**dadurch gekennzeichnet,**
daß ein erster Betriebsmodus (ENVTEST) vorgesehen ist, bei dem eine Bitmusterfolge von außerhalb des Bausteins über Bausteinanschlüsse dem zur Signaturbildung ausgebildeten rückgekoppelten Schieberegister zugeleitet wird und daß ein zweiter Betriebsmodus (ENVBIST) vorgesehen ist, bei dem die Bitmusterfolge von einem zur Erzeugung einer Bitmusterfolge ausgebildeten rückgekoppelten Schieberegister bausteinintern zur Signaturbildung ausgebildeten rückgekoppelten Schieberegister zugeleitet wird.

3. Elektronischer Baustein nach Anspruch 1 oder 2 mit einer Schaltung zur daten- und adressenbezogenen Ansteuerung von bausteinextern angeordneten und über Daten- und Adreßleitungen mit Bausteinanschlüssen verbundenen Nur-Lese- und/oder Schreib/Lese-Halbleiterspeicher.

4. Elektronischer Baustein nach Anspruch 3,
**dadurch gekennzeichnet,**
daß den Bausteinanschlüssen, an denen Halbleiterspeicher mit ihren Adreßleitungen angeschlossen sind, eine von einem nicht-linear rückgekoppelten Schieberegister erzeugte Bitmusterfolge zugeleitet wird und daß den Bausteinanschlüssen an denen Halbleiterspeicher mit ihren Datenleitungen angeschlossen sind, eine von einem linear rückgekoppelten Schieberegister erzeugte Bitmusterfolge zugeleitet wird oder daß von den betreffenden Bausteinanschlüssen eine Bitmusterfolge einem rückgekoppelten Schieberegister zur Signaturbildung zugeleitet wird.

5. Registerelement zur Bildung eines Schieberegisters in einer zusammen mit einer Schaltung auf einem elektronischen Baustein befindlichen Prüfeinrichtung zur Realisierung einer taktgesteuerten Schieberegisterprüfarchitektur (Boundary-Scan) mit einem Signalpfad (SIP) zur Verbindung eines Schaltungseingangs/-ausgangs der Schaltung mit einem Bausteinanschluß (BA), und mit einem Schiebepfad (SCP) zum Anschluß an benachbarte Registerelemente des Schieberegisters, wobei im Signal- und im Schiebepfad (SIP, SCP) je ein Eingangswähler (MUX1, MUX2) mit einem alternativen Eingang (AE) angeordnet ist und im Schiebepfad (SCP) dem Eingangswähler (MUX2) eine erste Kippstufe (FF) nachgeschaltet ist,
**dadurch gekennzeichnet,**
daß Schaltmittel zur Bildung eines einer Testmustererzeugung oder einer Signaturbildung dienenden rückgekoppelten Schieberegisters in Verbindung mit benachbarten Schieberegisterelementen vorgesehen sind.

6. Registerelement nach Anspruch 5,
**dadurch gekennzeichnet,**
daß die Schaltmittel einen eingangsseitig im Schiebepfad (SCP) angeordneten Betriebsmodus gesteuerten Eingangswähler (MUX3) aufweisen, der mit seinem alternativen Eingang (AE) einen Einspeiseeingang für einen Rückkopplungspfad zur Verfügung stellt.

7. Registerelement nach Anspruch 6,
**dadurch gekennzeichnet,**
daß dem alternativen Eingang (AE) des Eingangswählers (MUX3) ein logisches Verknüpfungselement vorgeschaltet ist, bei dem ein Eingang als Einspeiseeingang für den Rückkopplungspfad (FB) dient und einem anderen Eingang im Falle eines zur Signaturbildung vorgesehenen Registerelementes ein weiterer betriebsmodusgesteuerter Eingangswähler (MUX4) vorgeschaltet ist, der an seinem alternativen Eingang (AE) mit einem Signalpfadausgang eines Registerelementes in einem rückgekoppelten Schieberegister zur Testmustererzeugung angeschlossen ist.

8. Registerelement nach Anspruch 7,
**dadurch gekennzeichnet,**
daß das logische Element im Falle eines zur Testmustererzeugung dienenden Registerelementes als EXCLUSIV-ODER-Gatter (EX1) ausgebildet ist und im Falle eines zur Signaturbildung dienenden Registerelementes aus zwei in Serie geschalteten EXCLUSIV-ODER-Gattern (EX1, EX2) gebildet ist.
